(19) Europäisches Patentamt
European Patent Office
Office européen des brevets

(11) **EP 4 621 485 A1**

(12) **EUROPEAN PATENT APPLICATION**

(43) Date of publication:
24.09.2025 Bulletin 2025/39

(21) Application number: 24164698.3

(22) Date of filing: 20.03.2024

(51) International Patent Classification (IPC):
*G03F 7/00* (2006.01)

(52) Cooperative Patent Classification (CPC):
G03F 7/706831; G03F 7/70683; G03F 7/706849

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventors:
• COENE, Willem, Marie, Julia, Marcel
5500 AH Veldhoven (NL)

• VAN PUTTEN, Eibert, Gerjan
500 AH Veldhoven (NL)
• TINNEMANS, Patricius, Aloysius, Jacobus
5500 AH Veldhoven (NL)
• KONIJNENBERG, Alexander, Prasetya
5500 AH Veldhoven (NL)
• BUIJS, Robin, Daniel
5500 AH Veldhoven (NL)
• TUKKER, Teus
5500 AH Veldhoven (NL)

(74) Representative: ASML Netherlands B.V.
Corporate Intellectual Property
P.O. Box 324
5500 AH Veldhoven (NL)

(54) **METROLOGY METHOD AND ASSOCIATED METROLOGY DEVICE**

(57)     Disclosed is a metrology apparatus and method. The method comprises obtaining metrology data relating to a measurement obtained by illuminating a periodic structure comprising at least one pitch with illumination comprising a wavelength and capturing at least a plurality of components of interest of said scattered radiation from said periodic structure at a detection image plane, said illumination comprising at least one incoherent dipole, each said incoherent dipole comprising two mutually incoherent monopoles, said scattered radiation passing through at least one angularly resolved plane between said periodic structure and detection image plane; selecting said wavelength and each said at least one pitch such that that mutually coherent interfering components of said components of interest are equidistant to an optical axis of said at least one angularly resolved plane; and determining a parameter of interest of the periodic structure from said scattered radiation.

Fig. 9

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

In many metrology applications, it is desirable to access the full electric field (i.e., intensity and phase) rather than only intensity. Holography tools enable this; however they require a reference beam and very stringent operation to ensure interference between the reference beam and measurement radiation beam. Other phase retrieval methods may comprise an iterative retrieval of phase; however these are computationally demanding,

It would be desirable to improve on present methods for measuring the full electric field in metrology applications.

SUMMARY

Embodiments of the invention are disclosed in the claims and in the detailed description.

In a first aspect of the invention there is provided a metrology method comprising: obtaining metrology data relating to a measurement obtained by illuminating a periodic structure comprising at least one pitch with illumination comprising a wavelength and capturing at least a plurality of components of interest of said scattered radiation from said periodic structure at a image plane, said illumination comprising at least one incoherent dipole, each said at least one incoherent dipole comprising two mutually incoherent monopoles, said scattered radiation passing through at least one angularly resolved plane between said periodic structure and detection image plane; selecting said wavelength and each said at least one pitch such that mutually coherent interfering components of said components of interest are equidistant to an optical axis of said at least one angularly resolved plane; and determining a parameter of interest of the periodic structure from said scattered radiation.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements (d) a third pair of illumination apertures combining the first and second pair of apertures;
- Figure 6(a) is a schematic illustration of a first metrology target usable in some embodiments disclosed herein; and Figure 6(b) is a schematic illustration of a second metrology target usable in some embodiments disclosed herein;
- Figure 7 is a schematic illustration of a detection pupil corresponding to a proposed metrology arrangement using dipole illumination;
- Figure 8 is a schematic illustration of an illumination pupil for a proposed metrology arrangement using a dual dipole illumination arrangement;
- Figure 9 is a schematic illustration of a detection pupil for a proposed metrology arrangement using the dual dipole illumination arrangement of Figure 8, in a single pitch target metrology context;
- Figure 10(a) is a schematic illustration of a detection pupil illustrated in Figure 8 (X-direction only) and Figure 10(b) is a schematic illustration of an intensity spectrum corresponding to the detection pupil of Figure 10(a);
- Figure 11(a) is a schematic illustration of a detection pupil for a proposed metrology arrangement enabling a larger range of wavelength and target pitch combinations to be used and Figure 11(b) illustrates a proposed masking arrangement to block unwanted diffraction orders;
- Figure 12(a) is a schematic illustration of an illumination pupil for a proposed metrology arrangement using a single dipole illumination arrangement a corresponding detection pupil; and Figure 12(b) is a schematic illustration of an alternative illumination and detection pupil to that of Figure 12(a) enabling a larger range of wavelength and target pitch combinations to be used;
- Figure 13(a) is a schematic illustration of a detection pupil for a proposed metrology arrangement using the dual dipole illumination arrangement of Figure 8, in a dual pitch target metrology context; Figure 13(b) illustrates the positions of individual diffraction orders in Figure 13(a) for a single direction only; and Figure 13(c) is a schematic illustration of an intensity spectrum corresponding to the detection pupil of Figure 13(a);
- Figure 14(a) is a schematic illustration of a detection pupil for a proposed metrology arrangement using the dual dipole illumination arrangement of Figure 8, in a further dual pitch target metrology context; Figure 14(b) illustrates the positions of individual diffraction orders in Figure 14(a) for a single direction only; and
- Figure 15 depicts a block diagram of a computer system for controlling a metrology method and/or device such as disclosed herein.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

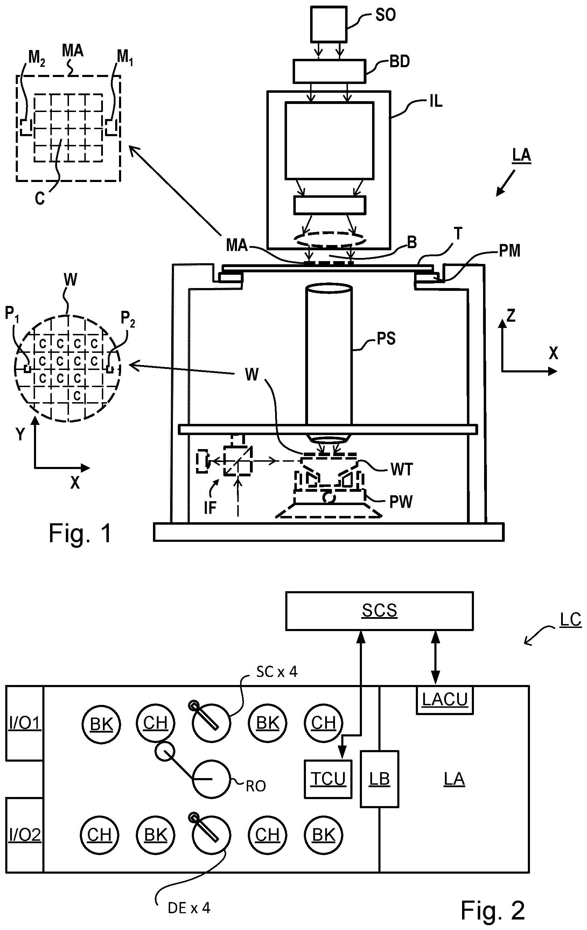

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

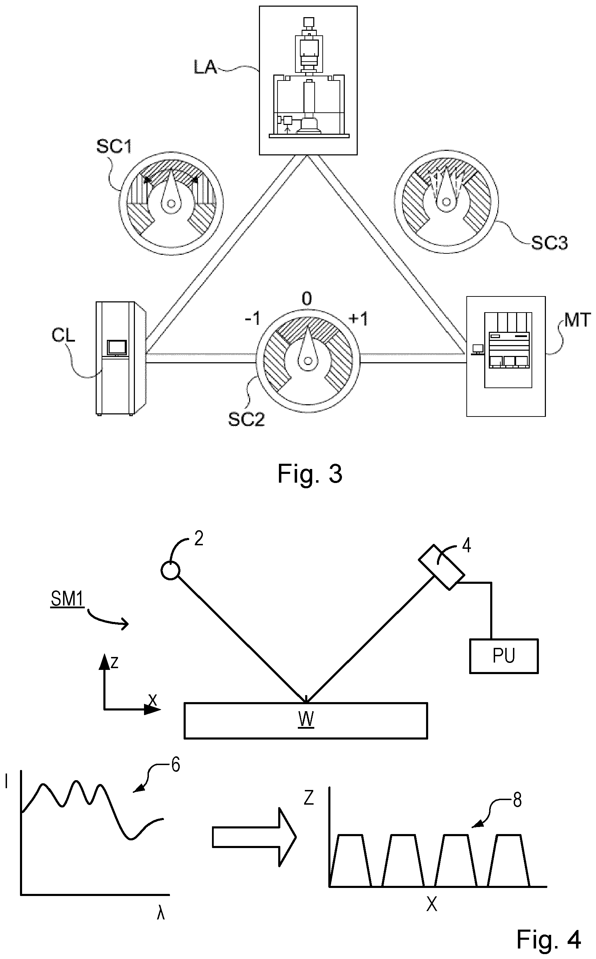

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers ca measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety. Other parameters of interest may be focus and dose. Focus and dose may be determined simultaneously by scatterometry (or alternatively by scanning electron microscopy) as described in US patent application US2011-0249244, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

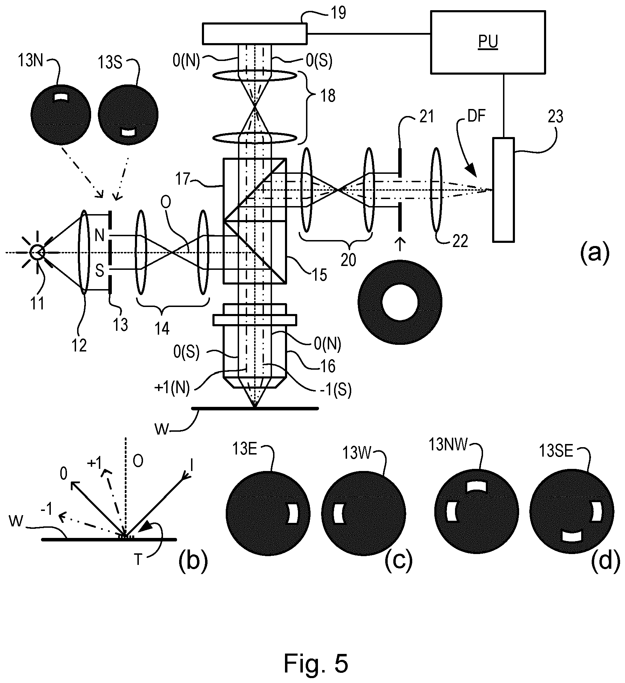

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 11 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane or angularly resolved plane. In particular, this can be done by inserting an aperture plate 13 of suitable form between lenses 12 and 11, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

As an alternative to a scatterometer, a metrology device may comprise a holographic microscope such as a digital holographic microscope (DHM) or digital dark-field holographic microscope. Such as device is disclosed, for example, in US2019/0107781 and WO2021121733A1 both of which is incorporated herein by reference.

In a scatterometry metrology tool, light may be used to create an image (e.g., at one or both of an image plane or pupil plane/angularly resolved plane) of a structure on a substrate. Such tools may measure the intensity or amplitude (or related measurement parameter such as diffraction efficiency) of the detected light, e.g., after having been scattered by the structure, and use this to determine one or more parameters of interest of the structure. In many cases, it may be beneficial to know the complex field (i.e., amplitude and phase) of the light scattered by the structure.

There are a number of present methods which enable the phase to be determined, in addition to the measured intensity/amplitude. One such technology is the aforementioned DHM, however holographic methods are typically subject to strict stability requirements and/or very low acquisition times, to suppress mechanical vibrations and/or drift and therefore achieve the necessary interference of the scattered radiation with reference radiation at the detector.

Another known method comprises performing multiple measurements under various conditions (e.g., different focus levels) and reconstructing the complex field of the scattered light using an iterative algorithm (e.g. as described in WO2021/121733, incorporated herein by reference). However, such methods are computationally very demanding/expensive and can be slow as a consequence, particularly as the accuracy of the retrieved phase is required to be higher in metrology than for more conventional phase retrieval applications such as microscopy and which require only the formation of an image. Other technologies are also known such as using masks having a pinhole or similar aperture in the detection branch of the tool, which allows an interferometric measurement (e.g. as described in WO2020/254041, incorporated herein by reference).

A non-iterative method for determining the complex field of the scattered radiation will now be described, based on causality, such as which applies in the (one-dimensional) time versus angular frequency context. This time causality stems from the fact that the electric field cannot travel faster than the speed of light, leading to an electric field $E=0$ for a time $t<0$ constraint. This time/causality constraint leads to a symmetry relationship of the electric field in the angular frequency domain. This symmetry relation is often referred to as the Kramers-Kronig relationship (and its inverse, which is the second Kramers-Kronig relationship). In an optical analogy of this concept, the time constraint may be replaced/implemented by locating a mask in the pupil plane (i.e., angularly resolved plane), such that the time coordinate $t$ becomes the pupil coordinate, and the angular frequency coordinate $\omega$ becomes the sensor/camera (image plane) coordinate. Because the Kramers-Kronig relationship comprises a linear integral transform (in essence a convolution operation), the (one-dimensional) Kramers-Kronig expression(s), expressed in terms of Fourier transforms, may be extended into a two-dimensional analysis; i.e., the two dimensions of the pupil plane/image plane. It can be appreciated however, that the methods disclosed herein are not limited to metrology based on Kramers-Kronig and/or Hilbert Transform principles, and such principles are not necessary to perform the metrology methods disclosed herein.

Applying the Kramers-Kronig relationship to non-iteratively extract phase information, and therefore the full field, requires applying the phase extraction algorithm to an intensity image which is the result of an optical field having a single-sided spectrum. Typically, this may be achieved by filtering out one side of spectrum (e.g., with respect to the specular beam) using a physical mask within the pupil plane. For example, the pupil edge may be used as the mask, e.g., by centering the specular beam (or each diffracted/scattered beam of interest in a dark-field embodiment) on the pupil edge in the pupil plane such that the edge clips (i.e., blocks) half of the beam.

However, masking the beam is non-optimal as it limits applicability of Kramers-Kronig based methods using, for example, a setup such as that illustrated in Figure 5(a) to certain situations such as a limited usable $\lambda/p$ range (where $\lambda$ is the wavelength(s) of the measurement radiation used and p is the target pitch) and/or limited coherence conditions for the measurement radiation and/or requires the provision of a dedicated mask in the pupil plane (which is not desirable).

In addition, present Kramers-Kronig based methods are typically employed in combination with the use of coherent illumination, e.g., for performing microscopy. For microscopy to work, it is important to reconstruct the full complex field accurately. Due to this requirement, a strict alignment of the specular reflection with the mask is required, as any misalignment would introduce an error term on the reconstructed field (due to the requirement for a single-sided spectrum), thereby introducing unwanted artifacts in the resulting microscopy image. However, it may be preferable to use illumination which is not coherent, e.g., partial coherent radiation. In particular, many present metrology apparatuses (e.g., such as that illustrated in Figure 5(a)) already use partial coherent illumination and it is desirable to use such apparatuses for non-iterative phase retrieval without significant hardware/source changes or spatial filtering of the light source, the latter option coming at the expense of light throughput. Also, using a coherent source makes the system sensitive to coherent imaging artifacts and reduces the robustness of any practical implementation due to the strict alignment requirements of the beam with respect to the mask.

Arrangements described herein may be used for example, in diffraction based metrology such as diffraction based overlay (DBO) or diffraction based focus (DBF) metrology. Diffraction based metrology such as DBO/DBF comprises comparing complementary diffraction orders (i.e., diffraction orders of the same order number either side of the specular beam such as the +1 and -1 diffraction orders; i.e., diffraction orders having the same magnitude diffraction angle with respect to the specular beam) to determine an asymmetry in the scattering structure or target, from which a parameter of interest (e.g., overlay or focus) can be extracted. The proposed method may comprise properly selecting wavelength and target pitch (e.g., $\lambda/p$ ratio) to enable suitable reconstruction of the electric field. The methods below will be described in the context of various overlay metrology techniques, but it will be readily apparent to the skilled person how to adapt the metrology techniques for measurement of focus.

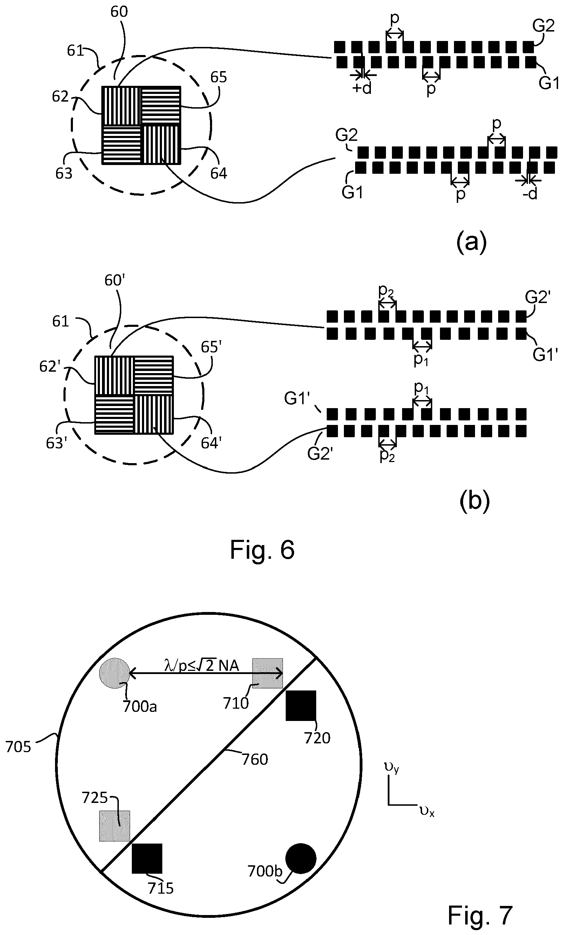

By way of a specific example, some arrangements disclosed herein may be used in the context of $\mu$DBO (micro-DBO) metrology. Figure 6(a) illustrates such a target 60 which may be measured with the targets overfilled, i.e., fully comprised within a measurement spot 61 during a measurement. Target 60 may comprise one or more sub-targets 62, 63, 64, 65. For example, the target 60 may comprise a pair of sub-targets per measurement direction; i.e., a first pair of sub-targets 62, 64 for measuring X-direction overlay and a second pair of sub-targets 63, 65 for measuring Y-direction overlay. Each of the sub-targets may comprise a respective periodic structure or grating in each of the two layers being compared in the overlay measurement; i.e., a first grating or bottom grating G1 and a second grating or top grating G2. All the gratings comprise the same pitch p, i.e., such that the target 60 comprises a single pitch p. Each sub-target of a pair of sub-targets may comprise a different bias, e.g., sub-targets 62, 63 may comprise a bias +d and sub-targets 64, 65 may comprise a bias -d.

Other arrangements described herein may be used in cDBO (continuous-DBO) metrology. Figure 6(b) illustrates such a target 60'. As in $\mu$DBO, target 60' may comprise one or more sub-targets, e.g., four sub-targets 62', 63', 64', 65' arranged as a pair of sub-targets per measurement direction; i.e., a first pair of sub-targets 62', 64' for measuring X-direction overlay and a second pair of sub-targets 63', 65' for measuring Y-direction overlay. Again, each of the sub-targets may comprise a respective periodic structure or grating in each of the two layers being compared in the overlay measurement; i.e., a first grating G1' and a second grating G2'. However, the second grating G2' and first grating G1' now have respective different pitches $p_1$, $p_2$. These pitches are interchanged between top and bottom gratings for the sub-targets of each directional pair; e.g., as shown here, the first grating G1' with pitch $p_1$ is the top grating for sub-target 64' and the bottom grating for sub-target 62' and the second grating G2' with pitch $p_2$ is the top grating for sub-target 62' and the bottom grating for sub-target 64'. These two sub-targets are typically referred to as "W" and "M" sub-targets, indicative of the interchange of the two pitches. Because of the two pitches, a "continuous bias" (e.g., a bias which continuously varies along the sub-target) is realized between top and bottom grating, which gives rise to a typical Moiré fringe in cDBO dark-field images. Overlay may be determined by comparing the respective phases of these Moiré fringes for the "W" and "M" sub-targets, e.g., comparing a corresponding one of the +1 and -1 diffraction orders, or the +1 and -1 diffraction orders summed together, from each of these sub-targets.

It can be appreciated that the term "periodic structure" described herein may comprise a compound periodic structure comprising respective gratings in two (or more) layers and/or multiple sub-targets (each having respective gratings in two or more layers) for measuring in different measurement directions and/or comprising different biases or grating order. However, single layer targets are also possible, e.g., in a focus metrology context.

Figure 7 illustrates a proposed alternative exit pupil or detection pupil (angularly resolved plane) arrangement to those presently used, which enables greater flexibility in that it provides for the option of using partial coherent illumination rather than fully coherent illumination.

In such an arrangement, a dipole illumination is used, resulting in respective specular beams 700a, 700b in two opposed regions within the exit pupil 705 (i.e., representing the detection NA, with a value $NA$ for the detection NA described by the radius of the pupil). For example, the specular beams 700a, 700b may be diagonally opposed with respect to a pupil coordinate system $v_x$, $v_y$ defined by the measurement directions X, Y, e.g., 45 degrees with respect to this pupil coordinate system). One each of the +1X diffraction order 710, -1X diffraction order 715, +1Y diffraction order 720 and -1Y diffraction order 725 is captured within the detection NA 705. A diagonally oriented two-fold wedge having an edge 730 separating the exit-pupil into two equally sized halves allows simultaneous imaging of the two specular beams 700a, 700b and four diffraction orders 710, 715, 720, 725. As such, single acquisition or "single-shot" non-iterative phase retrieval for parameter of interest and/or diffraction based metrology, in two perpendicular directions of the substrate plane (e.g., X and Y directions), is possible using such an arrangement.

Note that the shading does not indicate that the two specular beams 700a, 700b and their respective diffraction orders are different, only to illustrate which captured diffraction order relates to which of the specular beams 700a, 700b (e.g., +1X diffraction order 710 and -1Y diffraction order 725 are part of the same diffraction pattern as specular beam 700a and, -1X diffraction order 715 and +1Y diffraction order 720 are part of the same diffraction pattern as specular beam 700b). Also note that the diffracted orders are represented as square solely to differentiate then from the specular beams in the drawing.

The theoretical maximum wavelength-over-pitch ($\lambda$/p) ratio of standard diffraction based metrology (e.g., using a metrology tool such as illustrated in Figure 5(a)) presently comprises twice the detection NA (e.g., in each respective measurement direction X, Y). By contrast, the arrangement illustrated in Figure 7, as is illustrated, comprises a maximum wavelength-over-pitch ($\lambda$/$\rho$) of $\sqrt{2}NA$, and therefore suffers from a loss in usable $\lambda$/p range of a factor $\sqrt{2}$. Secondly, this approach uses a 2-fold wedge as an optical element in the detection path; a solution without such a wedge is in principle advantageous.

Therefore, further improvements are proposed which further increase the usable $\lambda$/p range (e.g., to approximately 2$NA$ for at least some embodiments) and/or enable non-coherent (e.g., such as incoherent or partial coherent) illumination to be used. The proposed methods may enable and/or result in aberration correction; e.g., the proposed methods may result in the measured signals being insensitive (or less sensitive) to at least even order aberrations. The proposed methods may also result in the measured signals being insensitive (or less sensitive) to at least odd order aberrations. Alternatively, the methods may enable odd order aberrations being correctable in an additional step. Alternatively or in addition, the proposed methods may result in the measured signals being insensitive (or less sensitive) to stage vibration in the direction perpendicular to the substrate plane (out of plane vibrations).

It is proposed to use an illumination configuration comprising a single dipole comprising two mutually incoherent monopoles (which is referred to herein as an "incoherent dipole"), or an incoherent dipole per measurement direction. In the context described herein, an incoherent dipole may comprise a dipole for which its constituent monopoles are mutually incoherent. Where there are two incoherent dipoles, one per measurement direction, then all four monopoles may be mutually incoherent. Each of the monopoles per dipole may be equidistant to an optical axis (e.g., center of the NA) of the system. The monopoles per dipole may be symmetrically opposite within the NA, e.g., both equidistant to an optical axis and arranged linearly with the optical axis. It can be appreciated that each of the mutually incoherent monopoles of the at least one dipole all generate a respective single-sided spectrum in the exit pupil/detection pupil.

In addition to this, the wavelength of the measurement illumination (i.e., the one incoherent dipole or the two incoherent dipoles) and the one or more pitches of a target are selected such that mutually coherent interfering components of the scattered radiation from the target are equidistant to the optical axis, and optionally symmetrically opposite within the NA. Mutually coherent interfering components of the scattered radiation comprise components of the scattered radiation which are to be interfered towards a fringe-based pattern in the measured image to determine the parameter of interest (e.g., overlay or focus).

The wavelength and each said one or more pitches may be selected such that all components of interest of said scattered radiation are scattered to only two scattering locations per measurement direction within said at least one angularly resolved plane. In this context, components of interest of said scattered radiation comprise all diffraction orders of interest (e.g., two first diffraction orders per measurement direction, e.g., a positive first order and a negative first order) and, for the bright-field embodiments only, also the zeroth orders. For example, where there are two measurement directions, all components of interest are scattered to only four scattering locations within said at least one angularly resolved plane. In such embodiments, at least one of said two scattering locations per measurement direction receive two mutually incoherent components of said components of interest.

In a μDBO example, the mutually coherent interfering components of the scattered radiation may comprise (for each illumination monopole) a zeroth order (specular) component and a corresponding, mutually coherent first order (both comprising a single-sided spectrum). As such, it can be appreciated that such an embodiment is a bright-field metrology technique where the interference of zeroth order illumination with a diffraction order of interest is detected on the detector. To achieve this, in an embodiment, the illumination wavelength and target pitch may be selected such that the distance between the two monopoles of each incoherent dipole is λ/p (in terms of NA) or 1/p (in terms of spatial frequency, i.e., NA/λ). In this way, each specular beam will overlap in the detection (exit) pupil plane (intermediate angularly resolved plane) with a first order of which it is mutually incoherent (i.e., corresponding to the other monopole of the dipole).

Other μDBO arrangements are possible, however; e.g., another embodiment may use a single illumination dipole for measuring in two measurement directions. In such an arrangement, the dipole position, wavelength and target pitch may be selected such that mutually incoherent first orders overlap in the pupil plane. In such an embodiment, the -1X order corresponding to one illumination monopole may overlap with the -1Y order corresponding to the other monopole and the +1X order corresponding to one illumination monopole may overlap with the +1Y order corresponding to the other monopole. Such an arrangement is also a field metrology technique, such that the mutually coherent interfering components of the scattered radiation may comprise (for each illumination monopole) a zeroth order (specular) component and in this embodiment, two corresponding, mutually coherent first orders (one per measurement direction), with each of these mutually coherent interfering components being equidistant from the optical axis.

By contrast, a proposed cDBO example (or more generally, metrology using targets of two pitches) may comprise a dark-field metrology technique, where the zeroth order beams are blocked at the detection pupil plane (angularly resolved plane). In the cDBO example, the dipole positions, wavelength and pitches may be chosen such that mutually incoherent first orders (of which there will be two per target, a respective order for each of the constituent target pitches) overlap in the detection pupil plane. Such an arrangement means that there are (per-direction) two scattering locations in the detection pupil plane. Each of the scattering locations receives one first diffraction order resulting from interaction of a first monopole of the incoherent dipole and one of the target pitches and another first diffraction order resulting from interaction of a second monopole of the incoherent dipole and the other target pitch. These scattering locations may be equidistant (at least per direction) from the optical axis, and may be symmetrically opposed within the NA, such that the mutually coherent interfering components, which in this case comprise a first order resultant from a first target pitch and a first order resultant from a second target pitch which both correspond to a common illumination monopole, are also equidistant from the optical axis, and optionally may be symmetrically opposed within the NA.

A number of different examples will now be described which embody the concepts just described.

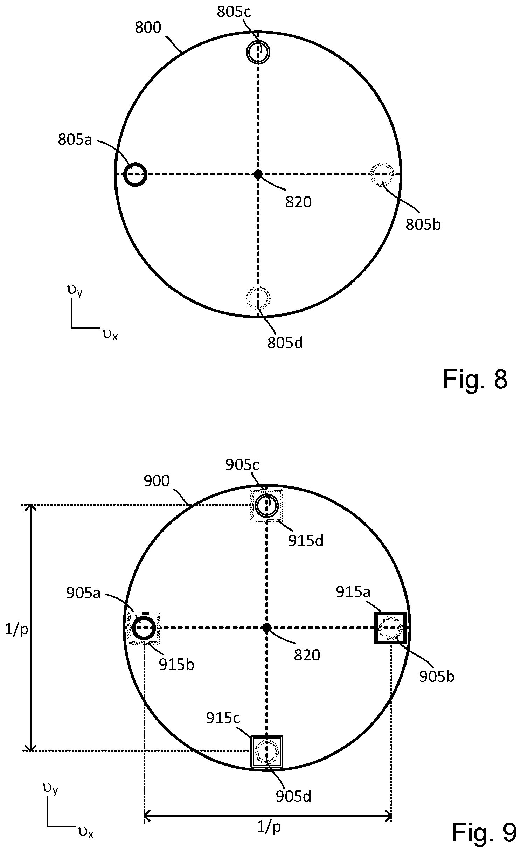

Figure 8 illustrates an illumination pupil 800 or illumination angularly resolved plane (in spatial frequency space $\upsilon_x$, $\upsilon_y$) describing an illumination arrangement which may be used in at least some μDBO and cDBO embodiments. The illumination pupil comprises a first incoherent dipole 805a, 805b for metrology in a first measurement direction (e.g., the X-direction) and a second incoherent dipole 805c, 805d for metrology in a second measurement direction (e.g., the Y-direction). Each respective dipole is substantially aligned orthogonal to the grating lines of the respective sub-targets of the overlay target it is to measure. More specifically, the first incoherent dipole 805a, 805b, which is used for X-direction parameter of interest metrology, is substantially aligned orthogonal to the grating lines of the X-direction sub-targets and the second incoherent dipole 805c, 805d, which is used for Y-direction parameter of interest metrology, is substantially aligned orthogonal to the grating lines of the Y-direction sub-targets). As such, the incoherent dipoles are substantially aligned with an apparatus coordinate system defined by the two measurement directions. Note that being substantially aligned does not require being precisely aligned, and substantially aligned may be understood to be within 10 degrees, within 5 degrees, within 3 degrees, within 2 degrees or within 1 degree of exact alignment. All four monopoles 805a, 805b, 805c, 805d (or the two monopoles in a single measurement direction embodiment) are mutually incoherent (in the drawing, each line style/shade combination signifies a different coherence state). This configuration may be similar to the dipole and quad illumination as used in lithographic scanners. The four monopoles are positioned symmetrically around the optical axis 820, i.e., such that they are equidistant from the optical axis 820 and such that each dipole is linearly aligned with the optical axis 820, i.e., with one dipole on the $\upsilon_x$ axis and the other dipole on the $\upsilon_y$ axis. Preferably the two incoherent dipoles are aligned mutually orthogonally. As has been described, an overlay target typically has four sub-targets, two for each direction.

Figure 9 is a schematic of the detection pupil (angularly resolved plane) for a μDBO embodiment using the illumination pupil of Figure 8. As with Figure 7, the circles denote the zeroth order reflection and squares denote the +/-1st order diffraction orders of interest (i.e., those captured within the detection NA 900). Each of the mutually incoherent specular reflections 905a, 905b, 905c, 905d is overlapped in the detection pupil 900 with a respective mutually incoherent first diffraction order 915a, 915b, 915c, 915d. A first mutually incoherent specular reflection pair 905a, 905b corresponds to the first incoherent dipole 805a, 805b and a second mutually incoherent specular reflection pair 905c, 905d corresponds to the second incoherent dipole 805c, 805d.

More specifically, for each mutually incoherent specular reflection pair, each constituent specular reflection overlaps with a first order diffraction with which it is incoherent (i.e., a first order diffraction which corresponds to the other specular reflection of the specular reflection pair). This may be achieved by choosing the wavelength and target pitch such that the two monopoles of each incoherent dipole (and therefore the two reflections of each specular reflection pair) are separated by 1/p in spatial frequency space. The line style/shade combination of each scattered radiation component signifies its coherence, i.e., such that specular reflection 905a is mutually coherent with diffraction order 915a (both resulting from the illumination monopole 805a) and no other of the scattered radiation components 905b, 905c, 905d, 915b, 915c, 915d; specular reflection 905b is mutually coherent with diffraction order 915b (both resulting from the illumination monopole 805b) and no other of the scattered radiation components etc..

When this detection pupil 900 is imaged (at a detector plane or image plane), the components which are mutually coherent will interfere, e.g., respective sets of mutually coherent interfering components comprising a specular reflection and corresponding diffraction order (e.g., components 905a, 915a will interfere, as will components 905b, 915b, components 905c, 915c and components 905d, 915d).

In the arrangement of Figures 8 and 9, the illumination monopoles, specular reflections and diffraction orders of interest are close to the edge of the detection pupil. In this manner, it is possible to provide for a large range for $\lambda/p \cong 2NA$ (actually, a bit smaller). No wedge is needed, such that a single image is detected in a single-shot acquisition.

The symmetry in the detection pupil enables digital aberration correction to be performed. The proposed symmetry of the mutually coherent interfering components (or at least their equidistance from the optical axis 820) makes it possible to disentangle the distilled complex-valued field into a product of a sample factor (which is a sum of two contributions from each of the monopoles of a incoherent dipole) and an aberration factor, such that the latter can be corrected for by deconvolution in a digital post-processing step. This is because there are only four scattering locations or "aberration positions" (or two in a single measurement direction embodiment), i.e., beam locations in the detection NA, with two overlapping beams per scattering locations. Each of the two beams at the same scattering locations will be subject to the same aberrations.

This aberration correction may be explained in a few simplified formulas. Denoting the first order (electric) fields for both left (L) monopole 805a and right (R) monopole 905b by $T_L$, $T_R$ and the aberration-related transfer functions for both left (L) monopole 805a and right (R) monopole 905b by $A_L$, $A_R$, the single-shot measurement can be made to yield a first order complex-valued signal S given by:

$$S = T_L\,A_L + T_R\,A_R$$

In a general case, $A_L \neq A_R$, and therefore no aberration correction is possible. For the specific case with the intended symmetry as described above, $A_L = A_R \stackrel{\text{def}}{=} A_C$ which is a factor common to both monopole contributions, such that the complex-valued signal can be described as:

$$S = (T_L + T_R)\,A_C$$

enabling correction for the common aberration factor $A_C$ by means of a simple deconvolution.

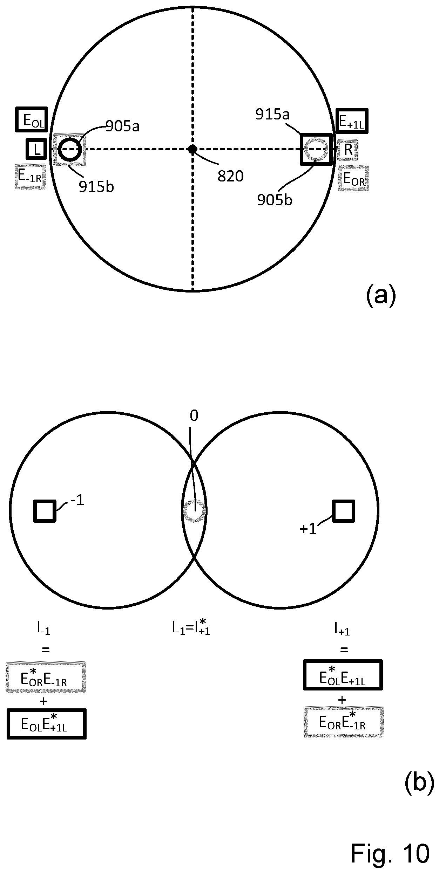

Figure 10 illustrates the relationship between object spectrum and image spectrum. Figure 10(a) illustrates the object spectrum in the detection pupil, corresponding to the detection pupil of Figure 9, and Figure 10(b) illustrates the corresponding image spectrum. For the sake of simplicity only the X-direction spectra are shown. Intensity $I$ is the incoherent sum of the intensity $I_L$ for the left L monopole and intensity $I_R$ for the left R monopole ($I = I_L + I_R$). Because the detector detects the power of the (aberration affected) object field, the image spectrum is the auto-correlation of the object spectrum in Fourier space i.e.,:

$$I_\upsilon = \int d\upsilon' E_{\upsilon+\upsilon'} E_{\upsilon'}^*$$

where $\upsilon$ is the spatial frequency coordinate in said Fourier space.

Consider the +1st order intensity $I_+$ of the image spectrum +1. This consists of a superposition of two contributions, one for each of the monopoles of the considered X-dipole. Each of these contributions is the cross-interference of the corresponding zeroth order of the object spectrum with either the +1st (from the left monopole L) or the -1st order (from the right monopole R) of the object spectrum: $I_+ = E_{0L}^* E_{+1L} + E_{0R} E_{-1R}^*$ , where $E_{0L}$, $E_{+1L}$, $E_{0R}$, $E_{+1R}$ are the electric fields of the zeroth order left monopole, +1 order generated from left monopole, zeroth order right monopole and +1 order generated from right monopole respectively. Note that the complex conjugation correctly flips from zeroth to first order when going from left to right monopole. Further note that $E$-fields are written here for simplicity, but at this stage they are image fields and not object fields, insofar that they include the effect of aberrations in terms of a phase-transfer function (with as phase the wave-aberration function expanded in aberration modes like Zernike polynomials).

Based on the above, a method for determining a value for a parameter of interest such as overlay from the detected image may comprise Fourier filtering one of the diffraction orders of the image spectrum (or alternatively performing a phase-retrieval via a Hilbert transform) to determine the electric field, performing an aberration correction on the complex valued result of the Fourier filtering, and inferring the parameter of interest from the aberration corrected field.

Fourier-filtering of the +1st order (or -1st order, the choice is arbitrary) of the image spectrum may comprise determining a filter region over which the Fourier filter extends. The extent of the Fourier filter depends *inter alia* on the size of the sub-targets in the metrology target: the smaller the sub-target, the larger the extent of its first orders in Fourier space (with the typical Fraunhofer-like patterns characteristic of diffraction by finite pads). At this stage, a transition is made from the bright-field (BF) information of the as-recorded BF image towards "first order" only information of a dark-field type. However, the first order of the BF image comprises information on the phases of the first orders as well as zeroth orders of the object field, with there being (in this embodiment) two superimposed interferences between zeroth and first orders. This method takes advantage of the single-sided nature of the diffraction information of the object field(s) (only +1st order object field information or only -1st order object field information for a given monopole). As such, the Fourier-filtered image spectrum $\tilde{I}_+$ for the +1st order may be described by:

$$I_+ = I_{+L} + I_{+R} = (E_{0L}^* E_{+1L} + E_{0R} E_{-1R}^*) A_C$$

where $E$ is a field in Fourier space and $A_C$ is the common aberration factor as both monopole terms have the same aberration dependence due to the symmetrical arrangement of the mutually coherent interfering components within the detection pupil. This aberration factor will relate to odd order aberrations only, the measured signals being insensitive to the even order aberrations due to the symmetry introduced by specific positions of zeroth and +/- first orders.

The aberration correction on the complex-valued information that results as output from Fourier-filtering step comprises the aberration function which applies to both the zeroth order and its related (mutually coherent) first order of the object field for each of the two monopoles of the considered dipole (X or Y). Because of the aforementioned symmetry in the detection pupil a single aberration correction can be applied (e.g., via deconvolution) which is common to both monopole contributions, to yield the aberration-corrected field. Note that the aberration term corrected by deconvolution may relate only to the odd-order aberrations; even order aberrations may be canceled in the overlay inference as described below.

The (e.g., aberration-corrected) field can be used to determine the parameter of interest (e.g., per measurement direction). The aberration-corrected field is a superposition of two contributions from the two monopoles of the considered dipole. Using an overlay example, overlay can be inferred in using a simple overlay DBO-model, for which the target comprises (per direction) two biased sub-targets with overlay biases $\pm d$ (i.e., as illustrated in Figure 6(a). However, this is only an example and other (e.g., a more sophisticated) models may be used, including those which may use more than two biased sub-targets per direction. As such, the methods described in general do not rely on any particular overlay model (nor a particular target design and/or particular number of sub-targets).

An example simple overlay model may be based on the first order diffraction field amplitude from the top grating being $E_{top} = re^{i\varphi_r}$ and from the bottom grating $E_{bot\pm1^{st}}^{\pm d} = t\,e^{i\varphi_t}e^{\pm1^{st}i(o\pm d)}$, where variable o and d are dimensionless scaled versions of overlay and the target bias (comprising a factor equal to $2\pi/p$ with $p$ the pitch of the grating). The overall diffraction amplitude equals:

$$E_{\pm1^{st}}^{\pm d} = re^{i\varphi_r}\left[1 + Ae^{i\varphi}\right]$$

where $A = t/r$, $\varphi = \Delta\varphi_{r\text{-}t} \pm 1^{st}(o \pm d)$, $\Delta\varphi_{r\text{-}t} = \varphi_t - \varphi_r$, and $r$ and $t$ are the diffraction coefficients of the top and bottom gratings respectively.

Sum $\Sigma$ and difference $\Delta$ complex-valued signals can be derived from the complex-valued aberration-corrected information $\tilde{\imath}_{rec,\pm d}^{abbcor}$ for both sub-targets (e.g., pads of an overlay target) having biases $\pm d$:

$$\Sigma \stackrel{\text{def}}{=} \Sigma\tilde{\imath}_{rec,\pm d}^{abbcor} = \tilde{\imath}_{rec,+d}^{abbcor} + \tilde{\imath}_{rec,-d}^{abbcor}$$

$$\Delta \stackrel{\text{def}}{=} \Sigma\tilde{\imath}_{rec,\pm d}^{abbcor} = \tilde{\imath}_{rec,+d}^{abbcor} - \tilde{\imath}_{rec,-d}^{abbcor}$$

As a (non-limiting) example, the (scaled dimensionless) overlay can subsequently be inferred by the following relation:

$$o = \arg\frac{Re\left\{\frac{\Sigma}{\Delta}\right\}}{\cot d + Im\left\{\frac{\Sigma}{\Delta}\right\}}$$

Such an overlay derivation may be impaired by zeroth order light leaking into the first orders of the image spectrum, particularly when the sub-target windows are oriented parallel to the grating lines. In case of 45 degree rotation of the sub-target windows with respect to the grating lines, this zeroth order light leaking into the first orders of the image spectrum will be severely reduced. This zeroth order light leaking affects the complex-valued sum signal $\Sigma$, and not the difference signal $\Delta$. Therefore an alternative overlay derivation which avoids the problem of zeroth order light leaking by using only the complex-valued difference signal $\Delta$ may take the form:

$$o = \text{atan}\left\{-\frac{Re\{\Delta\}}{Im\{\Delta\}}\right\}$$

As mentioned above, an alternative approach may use a Hilbert transform for phase retrieval (complex-valued field determination). The measured intensity can be described by:

$$I(x) \cong 2|c_0|^2\left|1 + e^{-ikx}\left(\frac{\left[\left[e^{+ikx}\,\beta_L(x)\right]*p(x)\right]}{2\,\tilde{p}(k)} + \frac{\left[\left[e^{-ikx}\,\beta_R(x)\right]*p(x)\right]^*}{\left(2\,\tilde{p}(-k)\right)^*}\right)\right|^2$$

where each monopole is modeled as a tilted incident beam at an angle $\pm\theta$ comprising a plane wave $e^{\pm ikx}$, $k = \frac{\sin\theta}{\lambda}$, $p(x)$ is a 2D-psf (point-spread function) of the imaging system comprising the aberration effects of the imaging optics, $\tilde{p}(\upsilon)$ is the Fourier transform of $p(x)$ (i.e., the phase-transfer function ), $\beta_L$ is the normalized scattered part of the object field having a spectrum towards the righthand-side of the left monopole, $\beta_R$ is the normalized scattered part of the object field having a spectrum towards the left-hand-side of the right monopole; and $|c_0|$ is the zeroth order amplitudes for both monopoles (i.e., assumed equal for both monopoles):

Applying the Hilbert Transform onto the above expression yields complex-valued image field:

$$i_{rec}(x) = \sqrt{2}\,|c_0|\left\{1 + e^{-ikx}\left(\frac{\left[e^{+ikx}\beta_L(x)\right]*p(x)}{2\,\tilde{p}(k)} + \frac{\left[e^{-ikx}\beta_R(x)\right]*p(x)}{\left(2\,\tilde{p}(-k)\right)^*}\right)^*\right\}$$

Taking the specific value of the spatial frequency around the position of the first order of the image spectrum (with the length of the diffraction vector given by $1/p = -2k$) :

$$v = -2k + \varepsilon$$

so that:

$$\tilde{i}_{rec}(v = -2k + \varepsilon) = \sqrt{2}\,|c_0|\left[\frac{\tilde{\beta}_L(-2k+\varepsilon)\,\tilde{p}(-k+\varepsilon)}{2\,\tilde{p}(k)} + \frac{\left(\tilde{\beta}_R(2k-\varepsilon)\right)^*\left(\tilde{p}(k-\varepsilon)\right)^*}{\left(2\,\tilde{p}(-k)\right)^*}\right]$$

Introducing the (phase-only) transfer function for the (2D) aberrations by its phase (with a separation in even and odd parts):

$$\chi(v) = \chi_e(v) + \chi_o(v)$$

$$\chi_e(-v) = \chi_e(v)$$

$$\chi_o(-v) = -\chi_o(v)$$

and considering small deviations $\varepsilon$ around the two positions in the exit pupil related to zeroth and $\pm$1st orders of the object fields, so that we can apply a first order Taylor expansion of these phases:

$$\frac{\tilde{p}(-k+\varepsilon)}{\tilde{p}(k)} \cong \left[e^{-2i\chi_o(k)}e^{i\varepsilon\nabla\chi_o(k)}\right]e^{-i\varepsilon\nabla\chi_e(k)}$$

$$\frac{\left(\tilde{p}(k-\varepsilon)\right)^*}{\left(\tilde{p}(-k)\right)^*} \cong \left[e^{-2i\chi_o(k)}e^{i\varepsilon\nabla\chi_o(k)}\right]e^{+i\varepsilon\nabla\chi_e(k)}$$

yields the following formula for the image field in Fourier space:

$$\tilde{i}_{rec}(v = -2k + \varepsilon)$$

$$\cong \frac{\sqrt{2}}{2}\,|c_0|\left[\tilde{\beta}_L(-2k+\varepsilon)\,e^{-i\varepsilon\nabla\chi_e(k)}\right.$$

$$\left. + \left(\tilde{\beta}_R(2k-\varepsilon)\right)^*e^{+i\varepsilon\nabla\chi_e(k)}\right]\left[e^{-2i\chi_o(k)}e^{i\varepsilon\nabla\chi_o(k)}\right]$$

Where the main aberration factor $e^{-2i\chi_o(k)}e^{i\varepsilon\nabla\chi_o(k)}$ (abbreviated as $A_C$ in the earlier description) is separated from the object fields. There is a remaining factor $e^{+i\varepsilon\nabla\chi_e(k)}$ still coupled to the individual fields related to both monopoles, which disappears in the overlay inference methods already described.

The arrangements described above show the illumination dipoles and therefore the diffraction orders of interest at the periphery of the detection pupil. However, assuming the same measurement wavelength is used and the illumination dipoles remain in the same locations, a change in target pitch (i.e., a larger pitch) will result in the diffraction orders of interest no longer overlapping with the opposing illumination monopole. This is because there are now eight scattering locations (aberration locations) within the detection pupil plane rather than four. Therefore the desired arrangement of the mutually coherent interfering components being equidistant to (e.g., and symmetrical with respect to) the optical axis is not fulfilled such that the desired aberration correction is no longer possible.

It is therefore proposed to extend the range of the usable $\lambda/p$ ratio by adapting the illumination pupil, e.g., by moving each monopole towards the optical axis by an equal distance (with respect to the arrangement of Figure 8), such that the distance between the monopoles of each incoherent dipole is maintained at $\lambda/p$ (or 1/p in terms of spatial frequencies), each monopole being equidistant to the optical axis; i.e., each monopole of a dipole is on the opposite side of the optical axis by point-inversion.

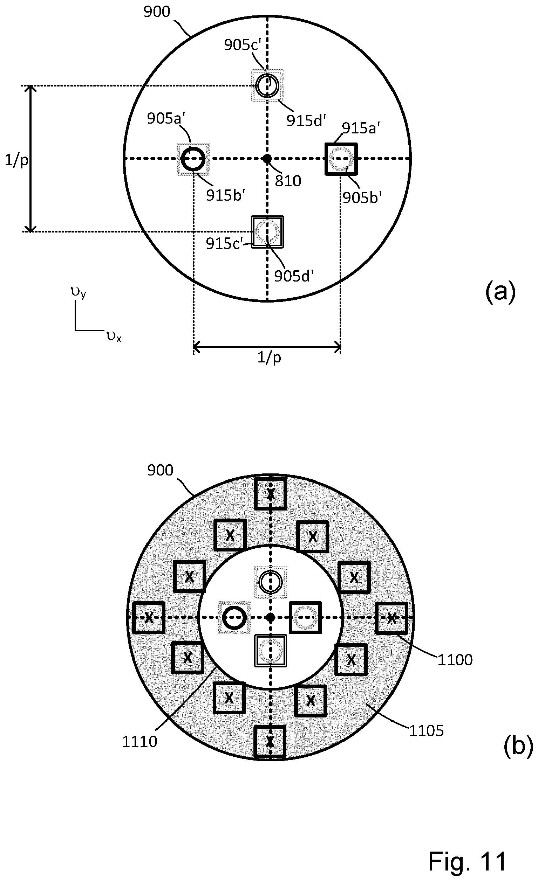

Figure 11(a) illustrates such an arrangement. The arrangement is essentially similar to that of Figure 9. Again, the wavelength and target pitch is such that the two monopoles of each incoherent dipole (and therefore the two reflections of each specular reflection pair) are separated by (a now smaller) 1/p in spatial frequency space. As before, it can be appreciated that specular reflection 905a' is mutually coherent with diffraction order 915a' (both resulting from the same illumination monopole) and no other of the scattered radiation components 905b', 905c', 905d', 915b', 915c', 915d'; specular reflection 905b' is mutually coherent with diffraction order 915b' and no other of the scattered radiation components etc..

It can be appreciated that for even smaller $\lambda/p$ ratios, there will be a point in which unwanted diffraction orders are diffracted into the regular detection pupil 900. These unwanted diffraction orders may comprise one or both of: a 2nd diffraction order on the same side of each diffraction order of interest and/or the opposite first diffraction order of each diffraction order of interest. As such, there may be multiple unwanted orders related to each of the (e.g., four) monopoles. These orders are termed unwanted since they do not allow for the disentanglement of aberration function and sample/object fields to enable aberration correction.

Figure 11(b) illustrates an arrangement for blocking these unwanted diffraction orders 1100 (shown with crosses, only one labeled). Such a method comprises providing a block 1105 defining an appropriately sized aperture 1110 so as to pass the wanted components while blocking the unwanted diffraction orders 1100. A configurable aperture arrangement comprising multiple detection apertures of different sizes (e.g., mounted on an aperture wheel) or a configurable iris mechanism may be provided such that an appropriate aperture sized can be selected in dependence of the $\lambda/p$ ratio. Such a configurable aperture arrangement may be located at an intermediate angularly resolved plane which is physically reachable (e.g., where the wedge is currently located in typical μDBO overlay metrology as presently performed). As such, the configurable aperture arrangement may be located at the same location as that of aperture stop 21 on Figure 5(a) (shown there for blocking a zeroth order in a conventional dark-field measurement).

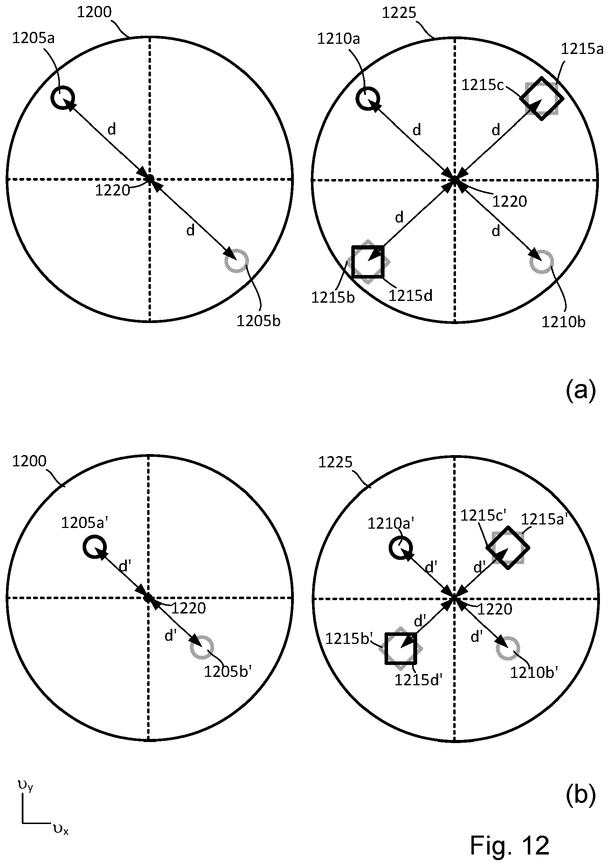

Figure 12 illustrates an alternative μDBO example, wherein the four scattering locations are arranged in a square arrangement. Figure 12(a) shows a proposed illumination pupil 1200 for such an embodiment comprises a single incoherent dipole 1205a, 1205b for measuring targets of two mutually perpendicular measurement directions. The incoherent dipole 1205a, 1205b has an angle magnitude substantially 45 degrees with respect to the two measurement directions (e.g., an apparatus coordinate system defined by the two measurement directions). Once again, being substantially aligned at 45 degrees to the coordinate system does not need to be necessarily precise and is subject to the previously described definitions. The two monopoles of the dipole 1205a, 1205b are equidistant at distance d from the optical axis 1220. Figure 12(a) also shows the corresponding detection pupil 1225. The $\lambda/p$ ratio is selected such that each diffraction order of interest 1215a, 1215b, 1215c, 1215d (as with previous embodiments, one first order per monopole, per direction) is diffracted to one of a pair of scattering locations in the detection pupil 1225, the pair of scattering locations being aligned perpendicular to the specular reflection 1210a, 1210b from the dipole illumination. As such, each of these scattering locations and the scattering locations which receive the specular reflection together form a square arrangement centered on the optical axis 1220, with each of the four scattering locations at a corner of the square and equidistant d from the optical axis 1220.

The arrangement is such that the mutually incoherent overlapping components are no longer a zeroth order and a first order, but two mutually incoherent first orders (one per measurement direction). As such, at one scattering location, an X diffraction order 1215b (corresponding to illumination monopole 1205b) overlaps a Y diffraction order 1215d (corresponding to illumination monopole 1205a). Similarly, at the other scattering location, a Y diffraction order 1215a (corresponding to illumination monopole 1205b) overlaps an X diffraction order 1215c (corresponding to illumination monopole 1205a).

The metrology method in this embodiment is still a bright-field measurement. The mutually coherent interfering components comprise a first set of mutually coherent interfering components 1210a, 1215c, 1215d, and a second set of mutually coherent interfering components 1210b, 1215a, 1215b. Each component of each set of mutually coherent interfering components is equidistant d from the optical axis 1220.

Figure 12(b) illustrates that the arrangement illustrated in Figure 12(a) can be adapted to accommodate a greater range of $\lambda/p$ ratios, in manner similar in principle to that illustrated in Figure 11(a). As such, the illumination dipole 1205a', 1205b' can be moved closer to the optical axis 1220 with the monopoles remaining equidistant d' to the optical axis 1220. The $\lambda/p$ ratio should then be configured to retain the square arrangement described, i.e., such that mutually incoherent diffraction orders 1215a', 1215c' overlap at a first scattering location and mutually incoherent diffraction orders 1215b', 1215d' overlap at a second scattering location, the first and second scattering locations also being at the distance d' from the optical axis. Although not shown, such an arrangement may, if required, also utilize a configurable aperture arrangement (such as has been described) to block any unwanted diffraction orders.

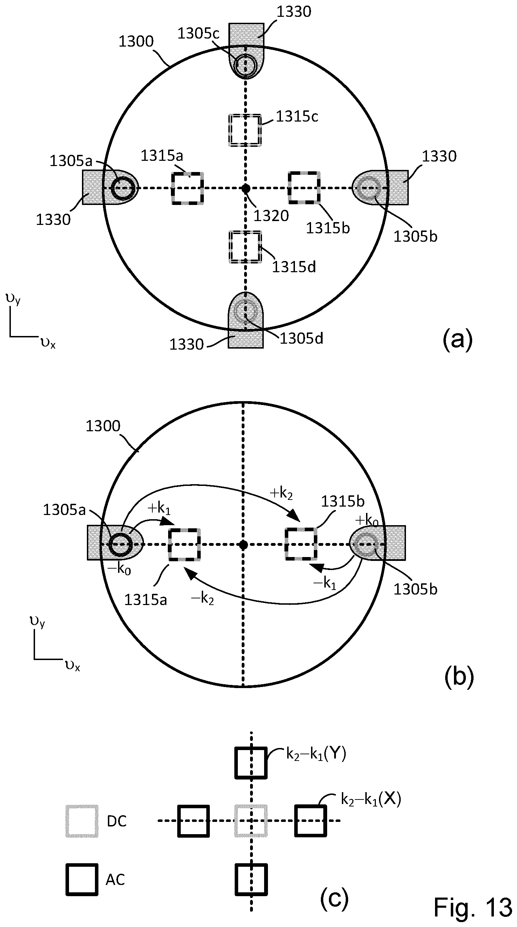

Figure 13(a) illustrates a detection pupil 1300 arrangement for cDBO metrology, or more generally metrology where the measured target comprises two pitches, wherein a single sub-target thereof may comprise a first pitch for the top layer and a second pitch for the bottom layer. In such an embodiment, the illumination profile may comprise the illumination pupil 800 illustrated in Figure 8, comprising an incoherent dipole comprising two mutually incoherent monopoles per measurement direction (e.g., where all four monopoles are mutually incoherent).

The method disclosed for cDBO is a dark-field method in that all of the specular beams 1305a, 1305b, 1305c, 1305d corresponding to the illumination monopoles 805a, 805b, 805c, 805d are blocked before the detector, e.g., in a angularly resolved plane. Any suitable mask or zeroth order block may be used to perform this blocking, such as zeroth order block 1330 illustrated in Figure 13, or an annular block 21 as illustrated in Figure 5(a).

The two target pitches $p_1$, $p_2$ means that, per illumination monopole, there are two first orders of interest (i.e., respective two first orders on one side of each specular beam, one corresponding to each of the two pitches). The proposed method comprises choosing the two ratios $\lambda/p_1$, $\lambda/p_2$ such that, per measurement direction, the four diffraction orders of interest are each diffracted to one of two scattering locations 1315a, 1315b, 1315c, 1315d, the scattering locations being equidistant to the optical axis 1320 (e.g., symmetrically arranged within the detection pupil 1300, and in addition, optionally positioned at two positions that have mutual point-inversion symmetry with respect to the point or location of the optical axis in the detection pupil or exit pupil).

Figure 13(b) illustrates the concept more clearly (showing one measurement direction only for clarity). At each scattering location 1315a, 1315b, there are two mutually incoherent diffraction orders, one per target pitch, each corresponding to a different illumination monopole of the incoherent dipole illumination. As such, scattering location 1315a receives one diffraction order resulting from interaction of illumination monopole 805a and first pitch $p_1$ and one diffraction order resulting from interaction of illumination monopole 805b and second pitch $p_2$. Similarly, scattering location 1315b receives one diffraction order resulting from interaction of illumination monopole 805a and second pitch $p_2$ and one diffraction order resulting from interaction of illumination monopole 805b and first pitch $p_1$. In terms of spatial frequencies, if the specular reflections 1305a, 1305b are at frequencies $-k_0$, $+k_0$ respectively, then the scattering locations 1315a, 1315b are respectively at $-k_0 + k_1 = +k_0 - k_2$ and $-k_0 + k_2 = +k_0 - k_1$, where $k_1 = 1/p_1$ and $k_2 = 1/p_2$.

As this method is a dark-field method, the mutually coherent interfering components of the scattered radiation comprise mutually coherent first orders per measurement direction, i.e., the two diffraction orders, one per target pitch, corresponding to one illumination monopole. As such, referring to Figure 13(b), the diffraction orders corresponding to illumination monopole 805a and respectively diffracted over diffraction vectors $+k_1$ and $+k_2$ form a first set or pair of mutually coherent interfering components and the diffraction orders corresponding to illumination monopole 805b and respectively diffracted over diffraction vectors $-k_1$ and $-k_2$ form a second set or pair of mutually coherent interfering components.

Figure 13(c) is an image spectrum of the captured dark-field image, comprising a direct component DC and two amplitude components AC per measurement direction. The parameter of interest may be derived from (an arbitrarily chosen) one of the amplitude components AC per direction (i.e., as depicted: either the right or left monopole for measurement in X, or the top or bottom monopole for measurement in Y).

For the X-direction, the capture image comprises a sum of two dark-field images, as generated by the monopoles at the left hand side and the right hand side, respectively. For each of these two dark-field images, there are two interfering diffraction orders, symmetrically positioned with respect to the optical axis. The dark-field image (for the X-direction) is the sum of two incoherent contributions from the left and the right monopoles, so that the Fourier spectrum of the dark-field image is described by:

$$\tilde{I}(v) = \tilde{I}_L(v) + \tilde{I}_R(v)$$

By means of the above symmetric alignment of the $k_1$ and $k_2$ diffraction orders, for each of the monopoles, all dZ-vibration effects (out-of-plane distortion) can be eliminated. dZ-vibration of the stage is similar to an instantaneous defocus; the effect of a defocus for these two symmetrically aligned orders that will be used further for dark-field imaging leads to an equal phase shift (defocus is in fact an even spherical aberration), which cancels to zero upon two-beam interference. The same argument holds for multiple wavelengths within a small but finite bandwidth $\Delta\lambda$ (which can also be seen as effective focal spreading due to the product of $\lambda$ and $dZ$ in the defocus-induced phase change).

Working in Fourier space enables analysis of the respective phase-shifts that can be observed in the dipole dark-field images of the respective first sub-target or M sub-target and second sub-target or W sub-target. The left monopole generates +first orders for first spatial frequency $k_1$ and second spatial frequency $k_2$, the right monopole generates -first orders for these spatial frequencies $k_1$, $k_2$. Each monopole generates these two diffraction orders which interfere with each other, and are summed together for each of the M and W sub-targets. Denoting the sub-target (or pad) by "P" (i.e., where P= M or W); then:

$$\tilde{I}_P(\nu) = \tilde{I}_{P,L}(\nu) + \tilde{I}_{P,R}(\nu)$$

and for the frequency of the Moiré fringe, in the image spectrum at $\nu = k_2 - k_1$, then:

$$\tilde{I}_P(\nu = k_2 - k_1) = \tilde{E}_P^{+1st}(+k_2)\,\tilde{E}_P^{+1st}(+k_1)^* + \tilde{E}_P^{-1st}(-k_2)^*\,\tilde{E}_P^{-1st}(-k_1)$$

Considering time-dependent 2D in-plane stage-vibrations: $\Delta x(t)$ (and $\Delta y(t)$ which is not explicitly mentioned here), and integrating over the acquisition time $\Delta t$, and denoting the resulting complex-valued "gain" (actually a "loss") as (note that the $\Delta z(t)$ vibrations are omitted since they cancel out due to the symmetry in position of the interfering orders):

$$c = |c|e^{i\varphi_c} = \frac{1}{\Delta t}\int_0^{\Delta t} dt\, e^{2\pi i\,(k_2 - k_1)\,\Delta x(t)}$$

in doing this, the effect of the 2D in-plane stage vibrations lead to both an amplitude effect via $|c|$ and a phase effect via $\varphi_c$.

As such, the expressions for $\tilde{I}_W$ and $\tilde{I}_M$ may be written as:

$$\tilde{I}_W(\nu = k_2 - k_1) = 2\,B_W\,T_W\,\cos\!\big(\varphi_{W,B} - \varphi_{W,T}\big)\,|c|e^{i\varphi_c}\,e^{2\pi i\,k_2\,o}$$

$$\tilde{I}_M(\nu = k_2 - k_1) = 2\,B_M\,T_M\,\cos\!\big(\varphi_{M,B} - \varphi_{M,T}\big)\,|c|e^{i\varphi_c}\,e^{-2\pi i\,k_1\,o}$$

where $T_W$, $T_M$ are the amplitudes of first order diffraction by the top grating for both "W" and "M" sub-targets; $\varphi_{W,T}$ and $\varphi_{M,T}$ are the phases for first order diffraction by the top grating for both "W" and "M" sub-targets; $B_W$, $B_M$ are the amplitudes of first order diffraction by the bottom grating for both "W" and "M" sub-targets and $\varphi_{W,B}$ and $\varphi_{M,B}$ are the phases for first order diffraction by the bottom grating for both "W" and "M" sub-targets.

In the dark-field Moiré-patterns for the sub-targets "W" and "M", the respective phase-offsets (scaled by $2\pi$) of the Moiré-fringes, denoted as $\psi_W$ and $\psi_M$ can be determined from the above equations as:

$$\psi_M = \varphi_c - k_1\,o$$

$$\psi_W = \varphi_c + k_2\,o$$

Taking the difference of these two phase-offsets, yields a direct relationship between the sum of the inverse pitches $k_1 = 1/p_1$ and $k_2 = 1/p_2$, and the overlay to be inferred, as given by:

$$\Delta\psi = \psi_W - \psi_M = (k_1 + k_2)\,o$$

note that in this case, overlay o is the (non-scaled) overlay value in nm (defined as the lateral shift of the bottom layer with respect to the top layer), given that $k_1$ and $k_2$ have the dimension of 1/m.

It can be seen that the dependence on the phase-offset $\varphi_c$ due to time-varying stage-shift $\Delta x = \Delta x(t)$ is cancelled out of the equation because of the difference taken in the respective phase-shifts. Note that the Moiré-fringes of the individual "M" and "W" sub-targets remain subject to the same instantaneous and time-varying fringe shift during the acquisition time $\Delta t$, which leads to a loss of fringe contrast since the above "gain" $|c| \le 1$ (which is actually a "loss"), but not to a fringe shift. The loss of fringe contrast is a remaining penalty, in terms of signal-to-noise of the amplitude of the Moiré fringes, due to in-plane stage-vibrations, which may be accounted for by other methods.

It can also be seen by further mathematical analysis that any field-independent or isoplanatic aberration term (i.e., both even and odd aberration terms) cancel out in the overlay determination of this embodiment.

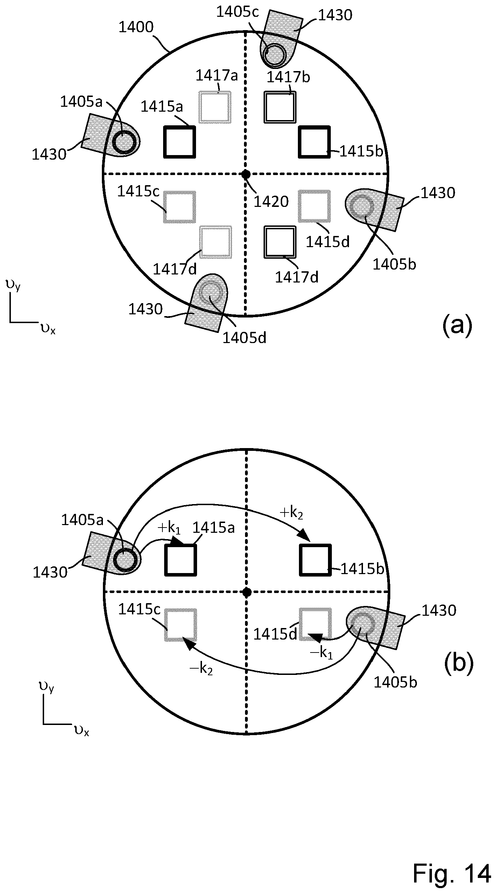

Figure 14 illustrates a variation on the cDBO dark-field arrangement of Figure 13. Figure 14(a) illustrates a detection pupil 1400 where the incoherent dipoles and therefore the zeroth orders 1405a, 1405b, 1405c, 1405d (again blocked by stop 1430) are off-axis. All four monopoles are again mutually incoherent. The angle of the incoherent dipoles with respect to the X/Y coordinate system may be any angle (e.g., with the two dipoles maintained mutually orthogonal), as it can be appreciated that the mutually coherent interfering components will be equidistant to the optical axis 1420 for all angles. The mutually coherent interfering components in the example comprise a first pair (X-direction) 1415a and 1415b, a second pair (X-direction) 1415c and 1415d, a third pair (Y-direction) 1417a and 1417b and a fourth pair (Y-direction) 1417c and 1417d. Figure 14(b) is an equivalent Figure to that of Figure 13(b) for this embodiment.

It can be appreciated that throughout this disclosure, the terms "left" monopole and "right" monopole are simply explanatory labels used to distinguish the monopoles of the X direction incoherent dipole with reference to the optical axis as illustrated in the Figure (i.e., on the left side or right side of the optical axis as drawn). More generally, the "left" monopole and "right" monopole are a first monopole of the first (X-direction) incoherent dipole and a second monopole of the first incoherent dipole. For Y direction metrology, the terms "left" and "right" may be replaced by "top" and "bottom" (more generally a first monopole of the second incoherent dipole and a second monopole of the second (Y-direction) incoherent dipole).

In an embodiment, the illumination may be provided using an illumination mode selector module. An illumination mode selector module is a form of spatial light modulation device (for example a multi-mirror array, MMA) or spatial light configuration device which enables control/configuration of the spatial pattern of the illumination pupil (i.e., the illumination configuration). However, other methods of configuring the illumination may be employed in such an apparatus, such as a more conventional spatial filter (e.g., as mounted to a filter wheel) with appropriate filtering configuration.

Using the concepts disclosed herein it is possible to perform non-iterative phase retrieval using incoherent or partial coherent illumination. This opens the applicability of such methods to a broader range of light sources, such as the ones currently used in many metrology devices. In this manner, a method of full-field metrology (e.g., with phase retrieved) may be achieved in a single acquisition (i.e. single shot). The inferred parameter of interest may be either insensitive, or less sensitive, to aberrations or aberration can be corrected for, e.g., by deconvolution. In addition, the inferred parameter of interest is (at least in some embodiments) insensitive, or less sensitive, to in-plane and/or out-of-plane stage vibration: the insensitivity for out-of-plane vibrations is realized through the symmetric alignment of the interfering diffraction orders with respect to the optical axis in the exit or detection pupil, whereas the insensitivity for in-plane vibrations is realized to the further combination (subtraction) of phases of the respective phases for W and M pads in the cDBO overlay target.

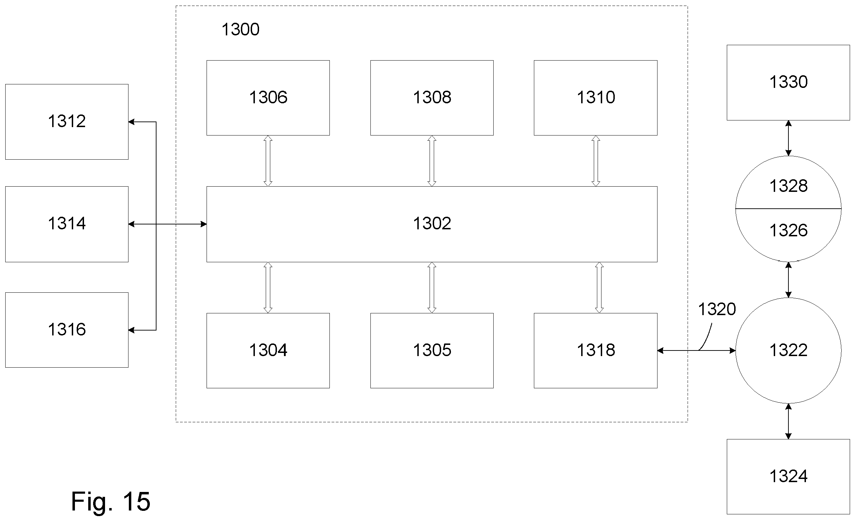

Figure 15 is a block diagram that illustrates a computer system 1300 that may assist in implementing the methods and flows disclosed herein. Computer system 1300 includes a bus 1302 or other communication mechanism for communicating information, and a processor 1304 (or multiple processors 1304 and 1305) coupled with bus 1302 for processing information. Computer system 1300 also includes a main memory 1306, such as a random access memory (RAM) or other dynamic storage device, coupled to bus 1302 for storing information and instructions to be executed by processor 1304. Main memory 1306 also may be used for storing temporary variables or other intermediate information during execution of instructions to be executed by processor 1304. Computer system 1300 further includes a read only memory (ROM) 1308 or other static storage device coupled to bus 1302 for storing static information and instructions for processor 1304. A storage device 1310, such as a magnetic disk or optical disk, is provided and coupled to bus 1302 for storing information and instructions.

Computer system 1300 may be coupled via bus 1302 to a display 1312, such as a cathode ray tube (CRT) or flat panel or touch panel display for displaying information to a computer user. An input device 1314, including alphanumeric and other keys, is coupled to bus 1302 for communicating information and command selections to processor 1304. Another type of user input device is cursor control 1316, such as a mouse, a trackball, or cursor direction keys for communicating direction information and command selections to processor 1304 and for controlling cursor movement on display 1312. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1300 in response to processor 1304 executing one or more sequences of one or more instructions contained in main memory 1306. Such instructions may be read into main memory 1306 from another computer-readable medium, such as storage device 1310. Execution of the sequences of instructions contained in main memory 1306 causes processor 1304 to perform the process steps described herein. One or more processors in a multi-processing arrangement may also be employed to execute the sequences of instructions contained in main memory 1306. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1304 for execution. Such a medium may take many forms, including but not limited to, non-volatile media, volatile media, and transmission media. Non-volatile media include, for example, optical or magnetic disks, such as storage device 1310. Volatile media include dynamic memory, such as main memory 1306. Transmission media include coaxial cables, copper wire and fiber optics, including the wires that comprise bus 1302. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1304 for execution. For example, the instructions may initially be borne on a magnetic disk of a remote computer. The remote computer can load the instructions into its dynamic memory and send the instructions over a telephone line using a modem. A modem local to computer system 1300 can receive the data on the telephone line and use an infrared transmitter to convert the data to an infrared signal. An infrared detector coupled to bus 1302 can receive the data carried in the infrared signal and place the data on bus 1302. Bus 1302 carries the data to main memory 1306, from which processor 1304 retrieves and executes the instructions. The instructions received by main memory 1306 may optionally be stored on storage device 1310 either before or after execution by processor 1304.

Computer system 1300 also preferably includes a communication interface 1318 coupled to bus 1302. Communication interface 1318 provides a two-way data communication coupling to a network link 1320 that is connected to a local network 1322. For example, communication interface 1318 may be an integrated services digital network (ISDN) card or a modem to provide a data communication connection to a corresponding type of telephone line. As another example, communication interface 1318 may be a local area network (LAN) card to provide a data communication connection to a compatible LAN. Wireless links may also be implemented. In any such implementation, communication interface 1318 sends and receives electrical, electromagnetic or optical signals that carry digital data streams representing various types of information.

Network link 1320 typically provides data communication through one or more networks to other data devices. For example, network link 1320 may provide a connection through local network 1322 to a host computer 1324 or to data equipment operated by an Internet Service Provider (ISP) 1326. ISP 1326 in turn provides data communication services through the worldwide packet data communication network, now commonly referred to as the "Internet" 1328. Local network 1322 and Internet 1328 both use electrical, electromagnetic or optical signals that carry digital data streams. The signals through the various networks and the signals on network link 1320 and through communication interface 1318, which carry the digital data to and from computer system 1300, are exemplary forms of carrier waves transporting the information.

Computer system 1300 may send messages and receive data, including program code, through the network(s), network link 1320, and communication interface 1318. In the Internet example, a server 1330 might transmit a requested code for an application program through Internet 1328, ISP 1326, local network 1322 and communication interface 1318. One such downloaded application may provide for one or more of the techniques described herein, for example. The received code may be executed by processor 1304 as it is received, and/or stored in storage device 1310, or other non-volatile storage for later execution. In this manner, computer system 1300 may obtain application code in the form of a carrier wave.

Further embodiments are disclosed in the subsequent list of numbered embodiments:

Embodiment 1 is a metrology method comprising:

obtaining metrology data relating to a measurement obtained by illuminating a periodic structure comprising at least one pitch with illumination comprising a wavelength and capturing at least a plurality of components of interest of said scattered radiation from said periodic structure at a detection image plane, said illumination comprising at least one incoherent dipole, each said at least one incoherent dipole comprising two mutually incoherent monopoles, said scattered radiation passing through at least one angularly resolved plane between said periodic structure and detection image plane;
selecting said wavelength and each said at least one pitch such that mutually coherent interfering components of said components of interest are equidistant to an optical axis of said at least one angularly resolved plane; and
determining a parameter of interest of the periodic structure from said scattered radiation.

Embodiment 2 is a metrology method as described in embodiment 1, wherein said selecting step further comprises selecting said wavelength and each said at least one pitch such that all said components of interest are reflected and/or scattered to only two scattering locations per measurement direction within said at least one angularly resolved plane.

Embodiment 3 is a metrology method as described in embodiment 2, wherein said two scattering locations per measurement direction are symmetrically arranged within said at least one angularly resolved plane with respect to the optical axis.

Embodiment 4 is a metrology method as described in embodiment 2 or 3, wherein at least one scattering location of said two scattering locations per measurement direction receives two mutually incoherent components of said components of interest.

Embodiment 5 is a metrology method as described in any preceding embodiment, wherein the periodic structure comprises a single pitch, and said plurality of components of interest comprise a zeroth order component for each monopole of said at least one incoherent dipole.

Embodiment 6 is aA metrology method as described in embodiment 5, wherein said mutually coherent interfering components comprise a set of a zeroth order and at least one mutually coherent first order for each monopole of said at least one incoherent dipole.

Embodiment 7 is a metrology method as described in embodiment 5 or 6, wherein said illumination comprises a single incoherent dipole for measuring in each of two measurement directions, wherein said single incoherent dipole is oriented at 45 degrees with respect to each of said measurement directions.

Embodiment 8 is a metrology method as described in embodiment 7, wherein said mutually coherent interfering components comprise a set of a zeroth order and two mutually coherent first orders for each monopole of said incoherent dipole, one said first order related to one of said two measurement directions, and the other said first order related to the other of said two measurement directions.

Embodiment 9 is a metrology method as described in embodiment 7 or 8, comprising selecting said wavelength and said pitch such that mutually incoherent first diffraction orders relating to respective different measurement directions overlap in said at least one angularly resolved plane.

Embodiment 10 is a metrology method as described in embodiment 5 or 6, wherein said illumination comprises an incoherent dipole per each of two measurement directions, wherein all four monopoles are mutually incoherent, each of said incoherent dipoles being substantially aligned with a respective measurement direction of said two measurement directions.

Embodiment 11 is a metrology method as described in embodiment 10, wherein said mutually coherent interfering components are symmetrically arranged within said at least one angularly resolved plane with respect to the optical axis.

Embodiment 12 is a metrology method as described in embodiment 10 or 11, comprising selecting said wavelength and said pitch such that the distance between the monopoles of each said at least one incoherent dipole equals the reciprocal of the pitch in terms of spatial frequency.

Embodiment 13 is a metrology method as described in any of embodiments 1 to 4, wherein the periodic structure comprises a first pitch and a second pitch, and said plurality of components of interest comprise only diffraction orders of interest and no zeroth order components.

Embodiment 14 is a metrology method as described in embodiment 13, comprising blocking said zeroth order components in the at least one angularly resolved plane.

Embodiment 15 is a metrology method as described in embodiment 13 or 14, wherein said illumination comprises a incoherent dipole per each of two measurement directions, wherein all four monopoles are mutually incoherent, each of said incoherent dipoles being substantially aligned with a respective measurement direction of said two measurement directions.

Embodiment 16 is a metrology method as described in embodiment 13, 14 or 15, wherein said mutually coherent interfering components are symmetrically arranged within said at least one angularly resolved plane with respect to the optical axis.

Embodiment 17 is a metrology method as described in any of embodiments 13 to 16, comprising selecting said wavelength, said first pitch and said second pitch such that, per measurement direction:

a first diffraction order resultant from the first pitch and a first monopole of the corresponding incoherent dipole overlaps in said least one angularly resolved plane with another, mutually incoherent, first diffraction order resultant from the second pitch and a second monopole of the corresponding incoherent dipole; and
a first diffraction order resultant from the second pitch and the first monopole overlaps in said least one angularly resolved plane with another, mutually incoherent, first diffraction order resultant from the first pitch and the second monopole.

Embodiment 18 is a metrology method as described in any preceding embodiment, comprising non-iteratively reconstructing a field of said scattered radiation; and
using said reconstructed field in said step of determining a parameter of interest of the periodic structure.

Embodiment 19 is a metrology method as described in embodiment 18, comprising deconvolving an aberration term from the reconstructed field prior to determining the parameter of interest of the periodic structure.

Embodiment 20 is a metrology method as described in embodiment 18 or 19, wherein said non-iteratively reconstructing a field comprises Fourier filtering one diffraction order per measurement direction of an image spectrum described by the metrology data or performing a phase-retrieval via a Hilbert transform on said metrology data to determine the electric field.

Embodiment 21 is a metrology method as described in any preceding embodiment, comprising blocking unwanted diffraction orders in said at least one angularly resolved plane.

Embodiment 22 is a metrology method as described in embodiment 21, comprising using a configurable aperture arrangement to perform said blocking said unwanted diffraction orders.

Embodiment 23 is a metrology method as described in any preceding embodiment, wherein said parameter of interest is overlay.

Embodiment 24 is a metrology method as described in any preceding embodiment, wherein any said step of selecting said wavelength and each said at least one pitch comprises additionally configuring a distance of each monopole of said at least one incoherent dipole with respect to said optical axis.

Embodiment 25 is a metrology method as described in any preceding embodiment, wherein said obtaining said metrology data comprises:

illuminating the periodic structure with said illumination comprising at least one incoherent dipole, each said incoherent monopole comprising two mutually incoherent monopoles;
capturing scattered radiation from said periodic structure as a result of said illuminating at a detection plane, said scattered radiation comprising said plurality of components of interest.

Embodiment 26 is a computer program comprising program instructions operable to perform the method of any of embodiments 1 to 25, when run on a suitable apparatus.

Embodiment 27 is a non-transitory computer program carrier comprising the computer program of embodiment 26.

Embodiment 28 is a processing device comprising:

a processor; and
the non-transitory computer program carrier of embodiment 27.

Embodiment 26 is a metrology apparatus being operable to perform the method of any of embodiments 1 to 25 or comprising a metrology apparatus as described in any one of the embodiments 27 to 33.

Embodiment 27 is a metrology apparatus as described in embodiment 26, comprising:

a substrate holder for holding a substrate;
projection optics for projecting illumination onto a substrate;
a detector for detecting said scattered radiation at a detection image plane.

Embodiment 28 is a metrology apparatus as described in embodiment 27, further comprising an incoherent illumination source for generating said illumination.

Embodiment 29 is a metrology apparatus as described in embodiment 27 or 28, comprising a configurable aperture arrangement being operable to block unwanted diffraction orders in dependence with said wavelength and/or each said at least one pitch in said at least one angularly resolved plane.

Embodiment 30 is a metrology apparatus as described in any of embodiments 27 to 29, comprising an illumination arrangement configured to emit at least one incoherent dipole, each said at least one incoherent dipole comprising two mutually incoherent monopoles, wherein each monopole of each said at least one incoherent dipole is equidistant from an optical axis of the metrology apparatus.

Embodiment 31 is a metrology apparatus as described in embodiment 30, wherein said at least one incoherent dipole comprises a single incoherent dipole oriented at 45 degrees with respect to an apparatus coordinate system defined by two orthogonal measurement directions.

Embodiment 32 is a metrology apparatus as described in embodiment 30, wherein said at least one incoherent dipole comprises an incoherent dipole per each of two orthogonal measurement directions, wherein all four monopoles are mutually incoherent, each of said incoherent dipoles being aligned with an apparatus coordinate system defined by the two measurement directions.

Embodiment 33 is a metrology apparatus as described in embodiment 30, 31 or 32, wherein said illumination arrangement is configured to vary the distance of each monopole from said optical axis.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquidcrystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A metrology method comprising:

    obtaining metrology data relating to a measurement obtained by illuminating a periodic structure comprising at least one pitch with illumination comprising a wavelength and capturing at least a plurality of components of interest of said scattered radiation from said periodic structure at a detection image plane, said illumination comprising at least one incoherent dipole, each said at least one incoherent dipole comprising two mutually incoherent monopoles, said scattered radiation passing through at least one angularly resolved plane between said periodic structure and detection image plane;
    selecting said wavelength and each said at least one pitch such that mutually coherent interfering components of said components of interest are equidistant to an optical axis of said at least one angularly resolved plane; and
    determining a parameter of interest of the periodic structure from said scattered radiation.

2. A metrology method as claimed in claim 1, wherein said selecting step further comprises selecting said wavelength and each said at least one pitch such that all said components of interest are reflected and/or scattered to only two scattering locations per measurement direction within said at least one angularly resolved plane.

3. A metrology method as claimed in claim 2, wherein said two scattering locations per measurement direction are symmetrically arranged within said at least one angularly resolved plane with respect to the optical axis.

4. A metrology method as claimed in claim 2 or 3, wherein at least one scattering location of said two scattering locations per measurement direction receives two mutually incoherent components of said components of interest.

5. A metrology method as claimed in any preceding claim,
wherein the periodic structure comprises a single pitch, and said plurality of components of interest comprise a zeroth order component for each monopole of said at least one incoherent dipole, and wherein said mutually coherent interfering components comprise a set of a zeroth order and at least one mutually coherent first order for each monopole of said at least one incoherent dipole.

6. A metrology method as claimed in claim 5,

wherein said illumination comprises a single incoherent dipole for measuring in each of two measurement directions, wherein said single incoherent dipole is oriented at 45 degrees with respect to each of said measurement directions, and

the metrology method comprising selecting said wavelength and said pitch such that mutually incoherent first diffraction orders relating to respective different measurement directions overlap in said at least one angularly resolved plane.

7. A metrology method as claimed in claim 5, wherein said illumination comprises an incoherent dipole per each of two measurement directions, wherein all four monopoles are mutually incoherent, each of said incoherent dipoles being substantially aligned with a respective measurement direction of said two measurement directions.

8. A metrology method as claimed in claim 7, comprising selecting said wavelength and said pitch such that the distance between the monopoles of each said at least one incoherent dipole equals the reciprocal of the pitch in terms of spatial frequency.

9. A metrology method as claimed in claim 7, comprising selecting said wavelength and said pitch such that the distance between the monopoles of each said at least one incoherent dipole equals the reciprocal of the pitch in terms of spatial frequency.

10. A metrology method as claimed in any of claims 1 to 4, wherein the periodic structure comprises a first pitch and a second pitch, and said plurality of components of interest comprise only diffraction orders of interest and no zeroth order components.

11. A metrology method as claimed in claim 10, comprising blocking said zeroth order components in the at least one angularly resolved plane, and wherein said illumination comprises a incoherent dipole per each of two measurement directions, wherein all four monopoles are mutually incoherent, each of said incoherent dipoles being substantially aligned with a respective measurement direction of said two measurement directions.

12. A metrology method as claimed claims 10 or 11, comprising selecting said wavelength, said first pitch and said second pitch such that, per measurement direction:

a first diffraction order resultant from the first pitch and a first monopole of the corresponding incoherent dipole overlaps in said least one angularly resolved plane with another, mutually incoherent, first diffraction order resultant from the second pitch and a second monopole of the corresponding incoherent dipole; and

a first diffraction order resultant from the second pitch and the first monopole overlaps in said least one angularly resolved plane with another, mutually incoherent, first diffraction order resultant from the first pitch and the second monopole.

13. A metrology method as claimed in any preceding claim, comprising non-iteratively reconstructing a field of said scattered radiation; and

using said reconstructed field in said step of determining a parameter of interest of the periodic structure.

14. A metrology method as claimed in claim 13, wherein said non-iteratively reconstructing a field comprises Fourier filtering one diffraction order per measurement direction of an image spectrum described by the metrology data or performing a phase-retrieval via a Hilbert transform on said metrology data to determine the electric field.

15. A metrology apparatus being operable to perform the method of any of claims 1 to 14.

Fig. 1

Fig. 2

Fig. 3

Fig. 4

Fig. 5

Fig. 6

Fig. 7

Fig. 8

Fig. 9

(a)

$I_{-1}$
=

| $E_{OR}^{*}E_{-1R}$ |
| --- |
+
| $E_{OL}E_{+1L}^{*}$ |

$I_{-1}=I_{+1}^{*}$

$I_{+1}$
=

| $E_{OL}^{*}E_{+1L}$ |
| --- |
+
| $E_{OR}E_{-1R}^{*}$ |

(b)

Fig. 10

Fig. 11

Fig. 12

(a)

(b)

(c)

Fig. 13

Fig. 14

Fig. 15

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | "METROLOGY METHOD AND ASSOCIATED METROLOGY DEVICE", RESEARCH DISCLOSURE, KENNETH MASON PUBLICATIONS, HAMPSHIRE, UK, GB , vol. 720, no. 7 28 February 2024 (2024-02-28), XP007152420, ISSN: 0374-4353 Retrieved from the Internet: URL:https://www.researchdisclosure.com/database/RD720007 [retrieved on 2024-02-28] * paragraphs [0046] - [0050], [0062] - [0070]; figures 5,7,8 * | 1-15 | INV. G03F7/00 |
| A | "METROLOGY METHOD AND ASSOCIATED METROLOGY DEVICE", RESEARCH DISCLOSURE, KENNETH MASON PUBLICATIONS, HAMPSHIRE, UK, GB , vol. 719, no. 90 15 February 2024 (2024-02-15), XP007152364, ISSN: 0374-4353 Retrieved from the Internet: URL:https://www.researchdisclosure.com/database/RD719090 [retrieved on 2024-02-15] * paragraphs [0035] - [0041], [0046] - [0050]; figure 5 * | 1-15 | |
| A | WO 2023/154255 A1 (KLA CORP [US]) 17 August 2023 (2023-08-17) * paragraphs [0032] - [0037]; figures 1A, 2A- 2C * | 1-15 | |

TECHNICAL FIELDS SEARCHED (IPC)

G03F

The present search report has been drawn up for all claims

| Place of search | Date of completion of the search | Examiner |
|---|---|---|
| Munich | 17 October 2024 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 4698

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2024

| Patent document cited in search report | Publication date | Patent family member(s) | | Publication date |
|---|---|---|---|---|
| WO 2023154255 A1 | 17-08-2023 | CN | 117980692 A | 03-05-2024 |
| | | TW | 202348957 A | 16-12-2023 |
| | | US | 2023259040 A1 | 17-08-2023 |
| | | US | 2024329543 A1 | 03-10-2024 |
| | | WO | 2023154255 A1 | 17-08-2023 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B

- US 12922587 B
- US 13000229 B
- US 13033135 B
- US 13533110 B
- US 13891410 B
- WO 2011012624 A
- US 20160161863 A
- US 20160370717 A1
- US 20190107781 A
- WO 2021121733 A1
- WO 2021121733 A
- WO 2020254041 A